# EUROPEAN PATENT SPECIFICATION

(11) **EP 1 521 350 B1**
(45) Date of publication and mention of the grant of the patent: **25.07.2007**
(21) Application number: 04255970.8
(22) Date of filing: 29.09.2004
(51) Int. Cl.: H02K 11/00, H02K 15/00, G01R 31/34, G01D 5/20

(54) **Sensor probe with adjustable members**
Sonde mit einstellbaren Teilen
Sonde de capteur avec des élements réglables

(30) Priority: 03.10.2003 US 677287
(43) Date of publication of application: 06.04.2005
(73) Proprietor: GENERAL ELECTRIC COMPANY, Schenectady, NY 12345 (US)
(72) Inventor: Kliman, Gerald, Niskayuna New York 12309 (US); Shah, Manoj Ramprasad., Latham New York 12110 (US); Carl, Ralph James Jr., Clifton Park New York 12065 (US); Lee, Sang-Bin, Schenectady New York 12308 (US)
(74) Representative: Bedford, Grant Richard

(56) References cited:
- US-A- 5 341 095
- US-A- 5 990 688

## Description

This invention relates generally to sensor probes and, more particularly, to a universal magnetic sensor probe for use in the slot of an electrical machine wherein the probe includes adjustable members for use in a variety of electrical machines with different slot openings.

In the field of generating and utilizing electricity, it is important that elements of an electrical machine system remain fully functional over their expected working life so that unexpected downtimes and/or catastrophic failures can be avoided. To avoid such problems, it is important that elements such as large stators, which form part of the electrical machine systems are carefully inspected and tested during regular periodic maintenance or before being sold and installed, in particular, prior to electric power generating installation.

The stator core of electric machines utilizes thin insulated steel laminations to enable flux penetration and to reduce the eddy current flow for higher efficiency operation. The laminations are often stacked by placing a dovetail groove of the laminations in a dovetail of a key bar, which is attached to the frame. To hold the laminations together and to prevent lamination vibration, the core is axially clamped with a force of about 300~350 pound per square in (psi) (2.07 megapascal (MPa) ~ 2.41 MPa).

Short circuiting one lamination to another lamination can be caused by manufacturing defects, damage during assembly/inspection/rewind, stator-rotor contact, vibration of loose coil wedges/laminations, foreign magnetic material, etc. If the laminations are short circuited for any reason, a circulating fault current is induced. The circulating fault current increases with the number of shorted laminations and the conductivity between the laminations and the short/key bar. The fault current increases the power dissipation in the stator core and causes localized heating. The hot spots can progress to more severe localized heating and eventually cause burning or melting of the laminations. As a result, the stator bar insulation and windings can also be damaged causing ground current flow through the stator core and total destruction of the machines. Therefore, inter-laminar faults should be detected and repaired while damage is minor to prevent escalating damage and to improve the reliability of electric machine operation. Such faults may be detected by a sensor probe positioned within a slot opening of an electrical machine where variations in leakage flux produced with the stator suitably energized may be monitored.

Electric machines (e.g., generators, motors, etc.) of different designs will invariably have different widths of slot openings. In particular, different manufacturers provide electric machines having lamination teeth in varying sizes. Further, slot openings between the lamination teeth are also of different widths and sizes. As a result, a set of as many as 12-15 different sensor probes may be required to accommodate the varying slot openings of electric machines. There may be some instances where an exact fit or a desired air gap cannot be achieved by the pre-fabricated sensor probes. Therefore, inefficiencies such as higher manufacturing costs and increased efforts will result.

US 5,341,095 discloses a dynamoelectric machine stator test device.

US 5,990,688 discloses an apparatus and method for evaluation of a condition of a magnet circuit of an electric machine.

These and other drawbacks exist in current systems and techniques.

In accordance with an exemplary embodiment of the invention, an adjustable sensor head for use in multiple electric machines according to claim 1 is provided.

In accordance with other aspects of this particular exemplary embodiment of the invention, the first and second adjustable portions are sliding portions; the sliding portions are spring biased to provide a close fit between the pair of teeth which are lamination teeth; a surface of each of the sliding portions in contact with the pair of lamination teeth are coated with a slippery plastic material; a surface of each of the sliding portions in contact with the pair of lamination teeth are coated with one or more of iron powder and ferromagnetic fluid to reduce an effective air gap; the first and second adjustable portions are adjustable screws and the pair of teeth are lamination teeth; a surface of each of the adjustable screws in contact with the pair of lamination teeth are coated with a slippery plastic material; a surface of each of the adjustable screws in contact with the pair of lamination teeth are coated with iron powder to reduce an effective air gap; a surface of each of the adjustable screws in contact with the pair of lamination teeth are coated with a ferromagnetic fluid to reduce an effective air gap; the first and second adjustable portions are made of magnetic material; the magnetic material comprises one or more of laminations and soft magnetic composite; the first adjustable portion is a plurality of nested steel sheets providing a spring biased tension; the second adjustable portion is in communication with the plurality of nested steel sheets for contacting one of the pair of teeth; sensitivity in the ability to detect a change in flux pattern is increased by reducing air gap between the core and the pair of teeth, which are lamination teeth; and the core, first adjustable portion and the second adjustable portion comprise a magnetic material for effective flux transfer.

Aspects of the invention will now be described in more detail with reference to exemplary embodiments thereof as shown in the appended drawings, in which:
Figure 1 is a schematic front view showing the deployment of a probe or sensor depicting the leakage flux which occurs in the absence of a fault.
Figure 2 is a schematic front view similar to that shown in Figure 1, depicting a situation where a fault has occurred and the leakage flux has changed accordingly.
Figure 3 is an example of an adjustable sensor with sliding members in accordance with an embodiment of the invention.
Figure 4 is an example of an adjustable sensor with screw portions in accordance with an embodiment of the invention.
Figure 5 is an example of a corrugated lamination variable sensor in accordance with an embodiment of the invention.
Figure 6 is an example of a variable sensor with steel sheet bellows in accordance with an embodiment of the invention.

An aspect of the invention is directed to a universal sensor having a ferromagnetic

core including adjustable portions to fit various slot openings while maintaining a low magnetic reluctance and a secure mount for the coil. Another aspect of the invention is directed to incorporating sliding members. The sliding members may also include a spring bias for a close fit. Another aspect of the invention is directed to incorporating screw portions that may be adjusted to fit various slot openings. Another aspect of the invention is directed to a variable sensor head incorporating a series of corrugated laminations. Another aspect of the invention is directed to incorporating a series of sheet bellows between a core and an adjustable portion.

In brief, an embodiment of the invention may include a sensor or probe which includes a ferromagnetic core and a coil surrounding the core. The core may be disposed between opposed surfaces of a device. These surfaces may be the side walls of adjacent lamination teeth of a stator. The embodiments of the invention may be applied to different devices and/or applications.

The use of a sensor or probe having a core formed of a magnetic material provides a significant increase in the signal level as the sensor or probe provides a low magnetic reluctance path for the flux. The measured probe voltage may be approximately 2~3 orders of magnitude higher than that of an air core probe due in part to a high flux concentration in the probe. As a result, signal to noise ratio of the voltage measurement is improved. The sensor or probe may be disposed in a wedge depression area of a slot with a total air gap of up to 200 mils, for example, on either side of the probe.

According to another embodiment of the invention, the ferromagnetic core of the sensor head includes adjustable members to fit various slot openings while maintaining a low magnetic reluctance and a secure mount for the coil. The ferromagnetic core may be made variable to accommodate different slot openings. The core may be adjusted for no air gap and/or to maintain a predetermined air gap on either side. An embodiment of the invention is directed to an adjustable sensor head to fit a wide range of slot openings of varying width or size.

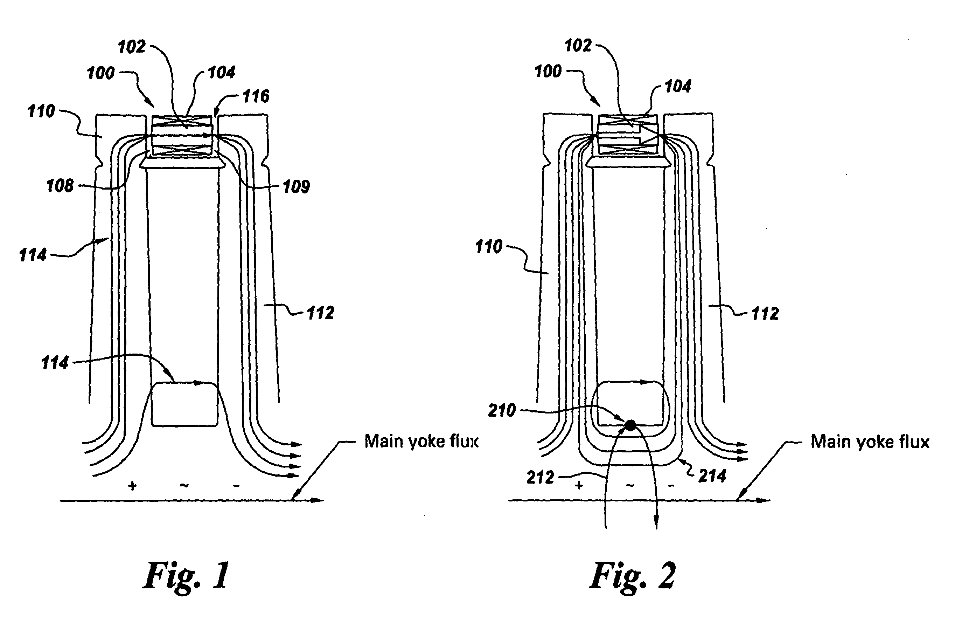

Figure 1 is a schematic front view showing the deployment of a probe or sensor depicting the leakage flux which occurs in the absence of a fault. As shown in Figure 1, sensor 100 is a fixed sensor head which includes a ferromagnetic core 102 and a coil 104 surrounding the core 102. Sensor 100 may be positioned in a wedge depression area 116. The coil 104 may be connected with a circuit arrangement. The core 102 may be located with respect to the laminated teeth 110, 112 so that air gaps 108, 109 are defined between the opposed surfaces of the adjacent teeth between which the sensor 100 is disposed, and the respective ends of the core 102. A laminated or molded (e.g., soft magnetic composite "SMC") ferromagnetic core 102 may be set between teeth 110 and 112. The fixed sensor head may also be used as an injection head or probe. A method for detecting core faults comprises (a) positioning a magnetic yoke near at least one tooth of the core, the magnetic yoke being wound by a winding; (b) supplying current to the winding to inject magnetic flux into the at least one tooth of the core; (c) measuring a signal (meaning at least one signal) resulting from the injected magnetic flux; and (d) using the measured signal to detect core faults. Sensor or probe 100 may be used to detect a change in flux pattern 114.

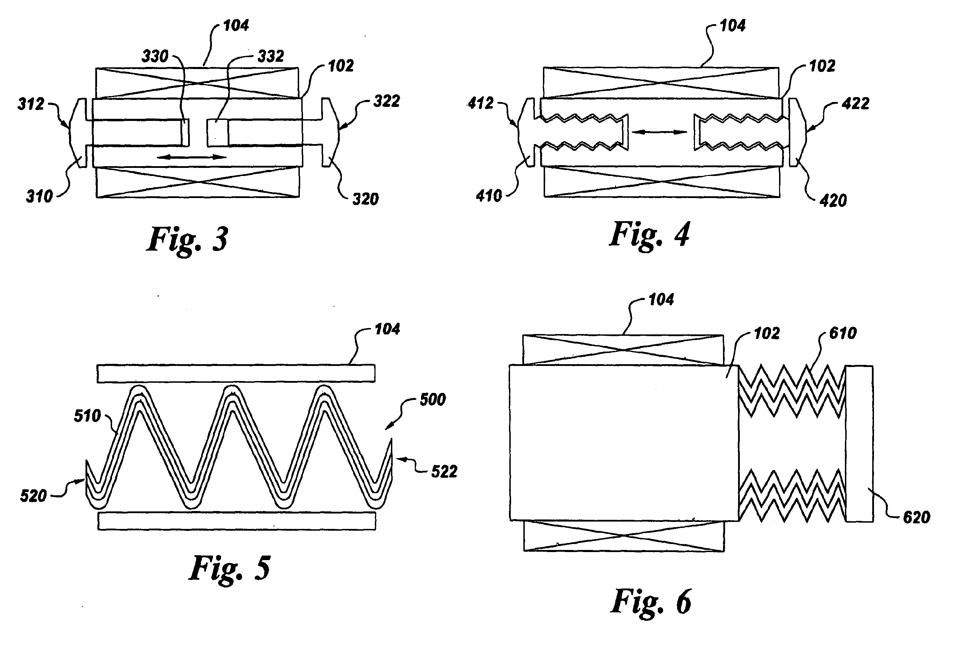

Figure 2 is a schematic front view similar to that shown in Figure 1, depicting a situation where a fault has occurred and the leakage flux has changed accordingly. As shown in this illustration, under fault conditions 210, the sensor 100 actively provides a path for resultant leakage flux due to fault current 212, as shown by 214. Further, flux level may be increased by several orders of magnitude.

According to an embodiment of the invention, sensor 100 may be more sensitive to a change in flux patterns as the air gaps between the sensor 100 and the lamination teeth 110, 112 are reduced. Therefore, the adjustable sensor of an embodiment of the invention may effectively reduce the air gap between the sensor 100 and the lamination teeth thereby increasing the sensitivity and ability to detect changes, such as changes in flux patterns. In addition, the adjustable sensor of an embodiment of the invention may be used with various electric machines of varying slot openings thereby promoting measurement efficiency. In another example, the adjustable sensor may be implemented to maintain a predetermined or specified air gap between the sensor 100 and lamination teeth 110, 112. Therefore, a single sensor may be used to fit a plurality of electric machines with different slot openings.

Figure 3 is an example of an adjustable sensor with sliding members in accordance with an embodiment of the invention. In particular, Figure 3 illustrates an adjustable probe with sliding members 310, 320 to fit in slot openings of varying width or size. According to another variation of an embodiment of the invention, a single sliding member may be used in place of multiple sliding members 310, 320. More specifically, a single sliding member may be formed by combining the ends at 330 and 332. The ferromagnetic core sensor 102 may be made adjustable by sliding members 310, 320 at either end. For example, some or all the parts may be made of a magnetic material, which may be laminated or molded, and fit closely together for effective flux transfer at any position. The sliding members 310, 320 may be adjusted for a desired fit. In another example, springs may be added at the back of the moving parts (e.g., sliding members 310, 320) at 330, 332 to hold the sensor active surfaces 312, 322 tightly against the lamination teeth to achieve maximum sensitivity. In this example, surfaces 312, 322 may be coated with a slippery plastic material and further loaded with a metallic powder (e.g., iron powder) to maintain permeability and reduce an effective air gap thereby enabling surfaces 312, 322 to slide on the laminations without damage. In another example, a ferromagnetic fluid may be used to reduce the effective air gap.

By reducing the air gap between the sensor and the lamination teeth, flux transfer may be enhanced. For example, as the change in geometry is minimal, the magnetic flux enters through one end, is collected in the core and moves through to the other end with low magnetic reluctance. Further, the reluctance of the path of the magnetic flux is minimal as compared to a path with air gaps.

Figure 4 is an example of an adjustable sensor with screw portions in accordance with an embodiment of the invention. Figure 4 illustrates an adjustable probe with screw portions 410, 420. The screw portions 410, 420 may be made of molded, powdered metal (e.g., soft magnetic composite) with screw threads for adjustability. The screw portions 410, 420 may be adjusted to fit a desired slot opening. In addition, surfaces 412, 422 may be coated with a slippery plastic material and further loaded with a metallic powder (e.g., iron powder) to reduce an effective air gap thereby enabling surfaces 412, 422 to slide on the laminations without damage. In another example, a ferromagnetic fluid may be used to reduce the effective air gap.

Figure 5 is an example of a corrugated lamination variable sensor head in accordance with an embodiment of the invention. In this embodiment, a ferromagnetic core 102 may be formed as (or include) corrugated laminations 500. surrounded by coil 104. Corrugated laminations 500 may be nested, wavy springs for holding the surfaces 520, 522 of the ferromagnetic core against the lamination teeth for minimizing gaps between the core and the lamination teeth. In this illustration, corrugated laminations 500 may include a plurality of sheets where 510 represents a single sheet. The corrugated laminations 500 may provide a spring biased effect to fit closely between slots of varying width or size. Further, each sheet 510 of the corrugated laminations 510 may be made of metallic material.

Figure 6 is an example of a variable sensor with a steel sheet bellows in accordance with an embodiment of the invention. Flux may be conducted through a series of nested bellows 610 that may also serve to spring load one of the sides of the sensor so that the sensor surface makes uniform contact with a wall of the lamination tooth. In this example, core 102 may include soft magnetic composite or laminated core. Other types of magnetic material may be used. Core 102 may be surrounded by coil 104. Nested steel sheet bellows 610 may connect to a side of core 102 and a member 620 where the nested steel sheet bellows 610 provides a spring biased tension to form a close fit between lamination teeth. Member 620 may be made of a similar magnetic material as core 102, or other metallic materials may be used.

Other magnetic materials may also include powered iron in a plastic binder, ceramic ferrite, iron wire bundle, and other equivalent materials.

## Claims

1. An adjustable sensor head for use in multiple electric machines with different width slot openings, the adjustable sensor head **characterized by**:
a ferromagnetic core (102);
a coil (104) surrounding the ferromagnetic core (102); and
a first sliding portion (310) and a second sliding portion (320) positioned in the ferromagnetic core (102) wherein the first sliding portion (310) and the second sliding portion (320) are adjustable to fit between a plurality of different width slot openings between a pair of teeth (110,112) of an electric machine.

2. The sensor head of claim 1, wherein the first and second sliding portions (310,320) together form a single sliding member.

3. The sensor head of claim 2, wherein the sliding portions (310,320) are spring biased to provide a close fit between the pair of teeth which are lamination teeth.

4. The sensor head of claim 3, wherein a surface (312,322) of each of the sliding portions in contact with the pair of lamination teeth are coated with a slippery plastic material.

5. The sensor head of claim 3, wherein a surface (312,322) of each of the sliding portions in contact with the pair of lamination teeth are coated with one or more of iron powder and ferromagnetic fluid to reduce an effective air gap.

6. The sensor head of claim 1, wherein the first and second adjustable portions (410,420) are adjustable screws and the pair of teeth are lamination teeth.

7. The sensor head of claim 1, wherein the first and second adjustable portions (310,320) are made of magnetic material.

8. The sensor head of claim 1, wherein the first adjustable portion (610) is a plurality of nested steel sheets providing a spring biased tension.

## Patentansprüche

1. Justierbarer Sensorkopf zur Verwendung in verschiedenen elektrischen Maschinen mit Schlitzöffnungen unterschiedlicher Breite, wobei der justierbare Sensorkopf **gekennzeichnet ist, durch**:
einen ferromagnetischen Kern (102);
eine Spule (104), die den ferromagnetischen Kern (102) umgibt; und
einen ersten Stellabschnitt (310) und einen zweiten Stellabschnitt (320), die in dem ferromagnetischen Kern (102) positioniert sind, worin der erste Stellabschnitt (310) und der zweite Stellabschnitt (320) justierbar sind, um in mehrere Schlitzöffnungen mit unterschiedlicher Breite zwischen einem Paar von Zähnen (110, 112) einer elektrischen Maschine zu passen.

2. Sensorkopf nach Anspruch 1, worin der erste und der zweite Stellabschnitt (310, 320) gemeinsam ein einziges Stellelement bilden.

3. Sensorkopf nach Anspruch 2, worin die Stellabschnitte (310, 320) mit einer Federvorspannung beaufschlagt sind, um eine gute oder enge Passung zwischen dem Paar von Zähnen zu bilden, die geblechte Zähne sind.

4. Sensorkopf nach Anspruch 3, worin eine Oberfläche (312, 322) von jedem der gleitenden Bereiche, die in Kontakt mit dem Paar der geblechten Zähne sind, mit einem glatten Kunststoffmaterial beschichtet ist.

5. Sensorkopf nach Anspruch 3, worin eine Oberfläche (312, 322) von jedem der Stellabschnitte, die in Kontakt mit dem Paar geblechten Zähne sind, entweder mit einem Eisenpulver und einer ferromagnetischen Flüssigkeit beschichtet ist, um einen auftretenden Luftspalt zu verringern.

6. Sensorkopf nach Anspruch 1, worin der erste und der zweite Stellabschnitt (410, 420) justierbare und verstellbare Schrauben sind und das Paar Zähne geblechte Zähne sind.

7. Sensorkopf nach Anspruch 1, worin der erste und der zweite Stellabschnitt aus einem magnetischen Material gefertigt sind.

8. Sensorkopf nach Anspruch 1, worin der erste Stellabschnitt (610) aus mehreren ineinander geschachtelten Stahlblechen besteht, die eine vorgespannte Federkraft bereitstellen.

## Revendications

1. Tête de capteur réglable destinée à être utilisée dans des machines électriques multiples avec des ouvertures de fente de largeur différente, la tête de capteur réglable **caractérisée par** :
un noyau ferromagnétique (102) ;
une bobine (104) entourant le noyau ferromagnétique (102) ; et
une première partie coulissante (310) et une deuxième partie coulissante (320) positionnées dans le noyau ferromagnétique (102) dans lequel la première partie coulissante (310) et la deuxième partie coulissante (320) sont réglables pour s'ajuster entre une pluralité d'ouvertures de fente de largeur différente entre une paire de dents (110, 112) d'une machine électrique.

2. Tête de capteur selon la revendication 1, dans laquelle la première et la deuxième parties coulissantes (310, 320) forment ensemble un élément coulissant unique.

3. Tête de capteur selon la revendication 2, dans laquelle les parties coulissantes (310, 320) sont contraintes par ressort pour fournir un ajustement étroit entre la paire de dents qui sont des dents laminées.

4. Tête de capteur selon la revendication 3, dans laquelle une surface (312, 322) de chacune des parties coulissantes en contact avec la paire de dents laminées sont recouvertes d'un matériau plastique glissant.

5. Tête de capteur selon la revendication 3, dans laquelle une surface (312, 322) de chacune des parties coulissantes en contact avec la paire de dents laminées est recouverte d'un ou plusieurs parmi une poudre de fer et un fluide ferromagnétique pour réduire un entrefer effectif.

6. Tête de capteur selon la revendication 1, dans laquelle la première et la deuxième parties réglables (410, 420) sont des vis réglables et la paire de dents sont des dents laminées.

7. Tête de capteur selon la revendication 1, dans laquelle la première et la deuxième parties réglables (310, 320) sont fabriquées dans un matériau magnétique.

8. Tête de capteur selon la revendication 1, dans laquelle la première partie réglable (610) est une pluralité de feuilles d'acier imbriquées fournissant une tension de contrainte par ressort.
